# FASCICULE DE BREVET EUROPEEN

(11) **EP 1 573 646 B1**
(45) Date de publication et mention de la délivrance du brevet: **22.11.2006**
(21) Numéro de dépôt: 03813691.7
(22) Date de dépôt: 17.12.2003
(51) Int. Cl.: G06K 7/00, G06K 19/077, H04Q 7/32

(54) **DISPOSITIF DE S CURISATION POUR CONNECTEUR DE MODULE DE S CURIT**
BEFESTIGUNGSEINRICHTUNG FÜR EINEN SICHERHEITSMODULVERBINDER
SECURING DEVICE FOR A SECURITY MODULE CONNECTOR

(30) Priorité: 20.12.2002 CH 20022179
(43) Date de publication de la demande: 14.09.2005
(73) Titulaire: NagraCard SA, 1033 Cheseaux-sur-Lausanne (CH)
(72) Inventeur: NICOLAS, Christophe, CH-1028 Préverenges (CH)
(74) Mandataire: Wenger, Joel-Théophile
(86) Numéro de dépôt international: PCT/IB2003/006046
(87) Numéro de publication internationale: WO 2004/057519

(56) Documents cités:
- WO-A-01/39101
- DE-A- 10 041 868

## Description

La présente invention concerne un dispositif électronique et mécanique permettant de détecter l'enlèvement et le remplacement d'un module de sécurité inséré dans un support de connexion.

On entend par module de sécurité une carte à puce avec contacts servant à contrôler un transfert d'informations vers un récepteur. Le module de sécurité, connecté au récepteur, est en général détachable. Il se charge de vérifier l'autorisation d'un traitement de données en fournissant des clés numériques nécessaires au fonctionnement du récepteur. La carte à puce peut être notamment de dimensions définies par les normes ISO 7816 ou d'un format plus réduit comme celui des cartes SIM utilisées en particulier dans les téléphones portables.

Par exemple, un décodeur de télévision à péage est pourvu d'un module de sécurité sous forme de carte à puce. Le rôle du décodeur est de décrypter un flux de données audio/vidéo numériques en fonction de droits accordés à un abonné stockés dans le module de sécurité. Les données du flux ne peuvent être décryptées que si ces droits sont valides. Plus précisément la décryption ne s'effectue que lorsque la clé contenue dans le module est valide et permet de décrypter les mots de contrôle CW contenus dans les messages de contrôle ECM accompagnant les données du flux.

Dans certaines applications, le module de sécurité est destiné à être inséré définitivement dans un appareil, théoriquement sans jamais devoir être retiré de l'appareil par la suite. Lors de la maintenance ou de la réparation de l'appareil, un changement de module de sécurité s'effectuera alors sous contrôle de l'organisme ayant délivré le module. Ce cas se présente par exemple pour des décodeurs de télévision à péage, dans lequel un décodeur est fourni à un utilisateur en même temps qu'un module de sécurité sous la forme d'une carte à puce de dimensions diverses.

Dans un tel contexte, deux cas sont possibles, à savoir:
- l'utilisateur doit introduire une fois pour toutes, le module en question dans le décodeur. Dans ce cas, il n'a normalement pas besoin de l'en extraire.
- le module de sécurité est introduit dans le décodeur lors de sa fabrication de manière irréversible sans que l'utilisateur soit même informé du fait que son décodeur contient un module qui ne doit être extrait que par une personne autorisée.

En général, un décodeur est fourni dans les conditions du premier cas, car le plus souvent le module de sécurité provient d'une source différente du décodeur lui-même. Ce dernier est équipé de moyens de connexion normalisés, acceptant des modules de sécurité sous forme de carte à puce de format ISO 7816 ou de celui des cartes SIM, qui permettent une insertion facile de modules par n'importe quel utilisateur.

En conséquence, il est aussi aisé de retirer les cartes de leur support ou accepteur sur lesquels ils sont connectés en exerçant une traction sur une partie de ces cartes. Ce type de manoeuvre n'est en général pas souhaitable et de surcroît non autorisé par l'organisme ou l'opérateur délivrant des droits de décryptage payants. En effet, l'opérateur désire éviter les échanges de modules de sécurité d'un décodeur vers un autre ou le remplacement du module par un module tiers.

Une manière connue d'empêcher le retrait abusif d'un module de sécurité est de bloquer mécaniquement celui-ci dans l'accepteur et lors de tentatives d'extraction, les moyens de blocage ou la manipulation de l'accepteur provoquent la destruction du module. La demande de brevet WO 01/39101 décrit des connecteurs pour accepteur de modules de sécurité muni de divers moyens de blocage et de destruction tel que:
- blocage par déversement de colle instantanée lors de l'insertion du module dans le connecteur.
- destruction par mise sous tension électrique élevée de contacts de l'accepteur ou échauffement local à haute température du module lors d'un début d'extraction.
- blocage du module par points d'ancrage dans le connecteur qui retiennent le module préalablement fragilisé par des rainures sur sa surface. Un retrait entraînant sa destruction mécanique.

Le point commun des dispositifs d'insertion irréversible de modules de sécurité décrits plus haut est la destruction du module en cas de retrait. De plus, dans certains cas, il n'est même plus possible de réinsérer un nouveau module dans l'accepteur car le connecteur est aussi endommagé, notamment dans le cas du blocage par collage ou dans le cas de la destruction par action électrique ou thermique.

Le but de la présente invention est de pallier cet inconvénient tout en permettant de contrôler le changement du module de sécurité et de désactiver l'appareil en cas d'enlèvement ou de remplacement non autorisé du module.

Le but est atteint par un dispositif selon la revendication 1.

L'étiquette de la première partie du dispositif se colle de manière à sceller le module de sécurité préalablement mis en place dans l'accepteur. Elle est constituée en général d'un film de papier ou de matière plastique prédécoupé parcouru sur une grande partie de sa surface par une antenne constituée d'un fil ou d'une piste conductrice connectée à une puce. Le transducteur de la seconde partie du dispositif, en général fixe, peut comporter soit une antenne incorporée dans une étiquette collée sous le connecteur du module de sécurité, soit une antenne imprimée sur la carte de circuit imprimé supportant le connecteur. Le rôle du transducteur est d'établir un dialogue avec la puce de la première étiquette par voie électromagnétique. Ainsi, une tentative de décollement de la première étiquette provoque le déchirement du film et la coupure du conducteur de l'antenne entraînant une rupture de la communication avec l'antenne du transducteur. Cette interruption est détectée par le processeur de l'appareil provoquant sa mise hors service. Seule une personne autorisée pourra réinitialiser l'appareil en remplaçant la première étiquette détruite, le module de sécurité pouvant être conservé.

L'invention sera mieux comprise grâce à la description détaillée qui va suivre et qui se réfère aux dessins annexés qui sont donnés à titre d'exemple nullement limitatif, dans lesquels:
La figure 1 illustre l'insertion d'une carte SIM dans un accepteur
La figure 2 montre un accepteur de carte SIM fermé muni du dispositif de sécurisation.
La figure 3 montre une coupe de l'accepteur de la figure 2
La figure 4 montre une variante d'un accepteur de carte SIM et la mise en place du dispositif de sécurisation.

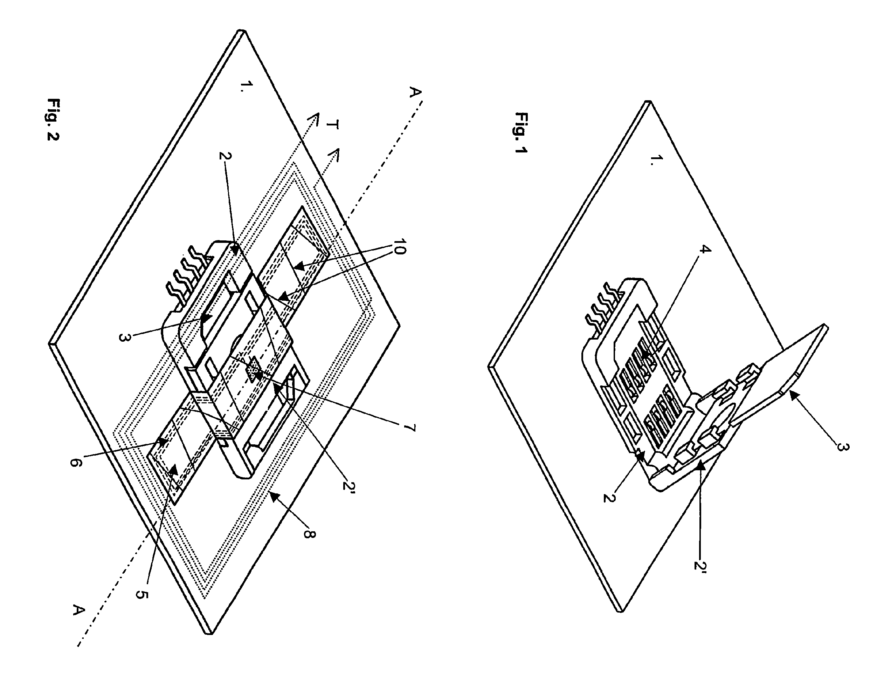

La figure 1 représente un accepteur de module de sécurité qui se présente sous forme d'un support (2) placé sur une carte de circuit imprimé (1) correspondant par exemple à la carte mère d'un décodeur. Ce support (2) muni d'un couvercle (2') articulé sur un des côtés comporte des glissières dans lesquelles un module de sécurité (3) est introduit. Dans l'exemple illustré, le format du module de sécurité correspond à celui d'une carte SIM dont une face est garnie de huit plages de contacts. Ces dernières sont dirigées vers huit contacts (4) correspondants du support (2) pour venir se connecter lorsque le couvercle (2') est rabattu sur le support (2) fermant ainsi l'accepteur afin de permettre la mise en service du module de sécurité (3).

La figure 2 illustre un exemple de configuration du dispositif de sécurisation selon l'invention dont la première partie est une étiquette (5) placée par-dessus le couvercle de l'accepteur et la seconde partie un transducteur dont la bobine d'antenne (8) est placée sous l'accepteur.

L'accepteur étant fermé, une étiquette (5) est collée simultanément sur le couvercle du support et de part et d'autre de ce dernier sur le circuit imprimé de manière à sceller l'accepteur. Cette étiquette (5) réalisée dans un film de matière isolante comporte une piste conductrice (6) reliée à une puce (7). La piste formant une bobine s'étend ici d'une extrémité à l'autre de l'étiquette. De plus, le film isolant est parcouru par des rainures (10) qui constituent autant de points faibles permettant une déchirure facilitée de l'étiquette en cas de tentatives de décollement. La piste conductrice qui peut être réalisée sous forme d'un fil métallique est incorporée dans la feuille isolante de l'étiquette et connectée à la puce (7). Elle constitue une antenne étalonnée à une fréquence de service de sorte que tout changement de longueur provoquée par sa rupture dû à un enlèvement de l'étiquette est détecté par la bobine d'antenne (8) du transducteur. Cette dernière est placée dans le voisinage immédiat de l'étiquette, et en général sous l'accepteur, émet un champ électromagnétique permettant l'alimentation en énergie de la puce de l'étiquette et l'échange de signaux numériques. La bobine (8) est connectée au circuit électronique du transducteur (T) qui est relié au processeur via une interface adéquate. Les signaux parcourant la bobine (8) du transducteur comprennent un numéro d'identification unique provenant de la puce (7) de l'étiquette (5). Le processeur analyse périodiquement ce numéro afin d'être comparé avec une référence enregistrée lors de l'installation du module de sécurité (3) dans l'accepteur. Lorsque les résultats de la comparaison sont positifs, l'appareil fonctionne normalement ce qui signifie que le module de sécurité (3) est bien celui prévu initialement.

Par contre, une comparaison erronée voire impossible, est due soit à un changement spontané d'étiquette, soit à une destruction de celle-ci par tentative d'enlèvement. En effet, une nouvelle étiquette est immédiatement détectée car sa puce contient un numéro d'identification différent de celui préalablement mémorisé. L'absence d'étiquette ou une étiquette dont la piste conductrice jouant le rôle d'antenne est endommagée est aussi détectée par le processeur car la comparaison avec le numéro de référence n'est plus possible. Le fonctionnement de l'appareil est ainsi suspendu jusqu'à ce qu'une réinitialisation complète soit effectuée par le service de maintenance avec une nouvelle installation d'un module de sécurité.

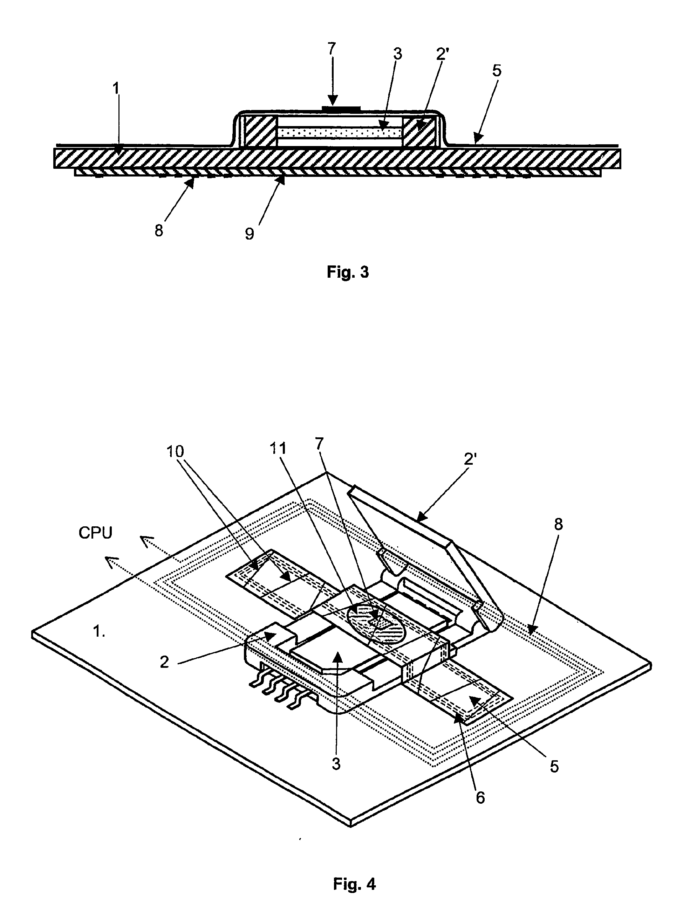

La figure 3 représente une coupe schématisée du dispositif de la figure 2 selon l'axe A-A. La bobine d'antenne (8) du transducteur est en général incorporée dans un film en matière isolante (9) constituant une seconde étiquette collée sous l'accepteur sur la face opposée de la carte de circuit imprimé (1).

Selon une autre variante du dispositif de l'invention, la seconde étiquette peut comporter des rainures analogues à celles de la première étiquette dans le but de la fragiliser. Cette sécurité supplémentaire empêche un accès au module de sécurité depuis la face inférieure de l'accepteur par soulèvement de l'étiquette par exemple. Une rupture de la bobine d'antenne du transducteur suite à un décollement de la seconde étiquette aura les mêmes conséquences que la rupture de la piste conductrice de la première étiquette.

Les étiquettes du dispositif selon l'invention peuvent être mises en place indifféremment sur l'une ou l'autre des faces de la carte de circuit imprimé. Dans l'exemple illustré, l'étiquette portant la bobine d'antenne du transducteur peut aussi bien se placer sur le couvercle de l'accepteur et l'étiquette portant la puce sur la face opposée de la carte. Dans une telle configuration, l'étiquette fermant l'accepteur comportera des rainures fragilisantes.

La figure 4 illustre une variante de l'accepteur de carte SIM et une autre possibilité de mise en place de l'étiquette (5) munie de la puce (7). Le module de sécurité (3) est inséré dans le support (2) de l'accepteur, puis l'étiquette (5) est collée à la fois sur le module de sécurité (3) et sur la carte de circuit imprimé (1) de part et d'autre du support (2). Une goutte de colle (11) est déposée sur l'étiquette dans la zone occupée par la puce (7) et finalement le couvercle (2') est rabattu sur le support (2) de façon à refermer l'accepteur. Grâce à la colle (11) solidarisant le couvercle (2) à l'étiquette, l'ouverture dudit couvercle (2) provoque le déchirement de l'étiquette (5) accompagné de la rupture de l'antenne (6).

Selon une autre variante de réalisation de l'invention, la bobine d'antenne du transducteur peut faire partie intégrante du circuit imprimé et gravée (ou étampée) en même temps que les autres pistes du circuit.

Quelle que soit la disposition du dispositif, l'extraction du module de sécurité endommage l'une ou l'autre étiquette en interrompant un conducteur servant d'antenne. Ce défaut est détecté par le processeur de l'appareil entraînant sa mise hors service.

## Revendications

1. Dispositif de sécurisation pour connecteur de module de sécurité (3), ledit connecteur faisant partie d'un accepteur (2, 2', 4) placé sur une carte de circuit imprimé (1) et intégré dans un appareil dont le fonctionnement, régi par un processeur (CPU), dépend du module de sécurité (3) connecté à l'accepteur (2, 2', 3), **caractérisé en ce qu'**il comprend une première partie constituée par une étiquette (5) collée de telle sorte à bloquer le module de sécurité (3) sur la carte de circuit imprimé (1), cette étiquette (5) comprenant au moins une puce (7) et une première antenne (6), et une seconde partie disposée dans le voisinage dudit connecteur, ladite seconde partie comportant une seconde antenne (8) d'un transducteur (T) communicant avec le processeur (CPU) de l'appareil, la puce de l'étiquette (7) étant apte à l'échange de signaux numériques au moyen de la première antenne (6) avec la seconde antenne (8).

2. Dispositif selon la revendication 1, **caractérisé en ce que** l'étiquette (5) comporte des rainures (10) facilitant son déchirement lors de tentatives de décollement.

3. Dispositif selon la revendication 1, **caractérisé en ce que** l'étiquette (5) est constituée d'un film de matière isolante incorporant une piste conductrice servant d'antenne (6) et une puce (7), ladite antenne (6) étant reliée à la puce (7).

4. Dispositif selon la revendication 1, **caractérisé en ce que** l'antenne (8) du transducteur (T) est placée sous l'accepteur (2, 2', 4).

5. Dispositif selon la revendication 4, **caractérisé en ce que** l'antenne (8) du transducteur (T) est incorporée dans un film mince (9) comportant des rainures facilitant son déchirement lors de tentatives de décollement.

6. Dispositif selon la revendication 1, **caractérisé en ce que** l'antenne (8) du transducteur (T) est réalisée sous la forme d'une bobine d'antenne gravée sur la carte de circuit imprimé (1).

7. Dispositif selon la revendication 1, **caractérisé en ce que** l'antenne (8) du transducteur (T) est agencée de sorte à émettre un champ électromagnétique permettant l'alimentation en énergie de la puce (7) de l'étiquette (5) et l'échange de signaux numériques au moyen de l'antenne (6) de l'étiquette (5).

8. Dispositif selon la revendication 7, **caractérisé en ce que** les signaux numériques comprennent un numéro d'identification unique provenant de la puce (7) via l'antenne (6) de l'étiquette (5), et **en ce que** le processeur (CPU) comporte des moyens d'analyse périodique et de comparaison dudit numéro avec une référence enregistrée lors de l'installation du module de sécurité (3) dans l'accepteur.

9. Dispositif selon la revendication 8, **caractérisé en ce que** les moyens de comparaison sont agencés de sorte à détecter un changement d'étiquette (5), respectivement de numéro d'identification, ledit changement altérant le fonctionnement de l'appareil.

10. Dispositif selon la revendication 1, **caractérisé en ce qu'**il comprend des moyens de détection d'une rupture de l'antenne (6) de l'étiquette (5) ou de l'antenne (8) du transducteur (T), lesdits moyens étant agencés de sorte à mettre l'appareil hors service lorsqu'au moins une antenne (6, 8) est interrompue.

11. Dispositif selon la revendication 1, dans lequel l'accepteur (2, 2', 4) comprend un support (2), placé sur la carte de circuit imprimé (1), muni d'un couvercle (2') adapté pour recevoir le module de sécurité (3), ledit support (2) comportant des contacts (4) se connectant à des contacts correspondant du module de sécurité (3) lorsque le couvercle (2') est rabattu sur le support (2), **caractérisé en ce que** l'étiquette (5) est collée simultanément sur le couvercle (2') du support (2) et sur la carte de circuit imprimé (1) de manière à sceller l'accepteur (2, 2', 4).

12. Dispositif selon la revendication 1, dans lequel l'accepteur (2, 2', 4) comprend un support (2) avec un couvercle (2'), ledit support (2), placé sur la carte de circuit imprimé (1) et adapté pour recevoir le module de sécurité (3), comporte des contacts (4) se connectant à des contacts correspondant du module de sécurité (3), **caractérisé en ce que** l'étiquette (5) est collée simultanément sur le module de sécurité (3) et sur la carte de circuit imprimé (1), le couvercle (2') étant maintenu rabattu sur le support (2) par une goutte de colle (11) déposée sur l'étiquette (5) de manière à refermer l'accepteur (2, 2', 4).

## Claims

1. Securing device for security module (3) connector, said connector forming part of an acceptor (2, 2', 4) located on a printed circuit board (1) and integrated into an apparatus whose functioning, controlled by a processor (CPU), depends on the security module (3) connected to the acceptor(2, 2', 4), **characterized in that** it includes a first part made up of a label (5) attached in such a way that it blocks the security module (3) on the printed circuit board (1), this label having at least one chip (7) and a first antenna (6) and a second part positioned in the vicinity of said connector, said second part including a second antenna (8) of a transducer (T) in communication with the apparatus processor (CPU), the chip (7) of the label being able to exchange digital signals by means of the first antenna (6) with the second antenna (8).

2. Device according to claim 1, **characterized in that** the label (5) includes grooves facilitating the tearing of said label if any removal is made.

3. Device according to claim 1, **characterized in that** the label (5) is made up of a film of insulating material incorporating a conductor path serving as an antenna (6) and a chip (7), said antenna (6) being linked to the chip (7).

4. Device according to claim 1, **characterized in that** the antenna (8) of the transducer (T) is placed under the acceptor.

5. Device according to claim 4, **characterized in that** the antenna (8) of the transducer (T) is incorporated in a thin film (9) and includes grooves facilitating the tearing of the latter if any attempt is made to remove it.

6. Device according to claim 1, **characterized in that** the antenna (8) of the transducer (T) is made in the form of an antenna coil etched on the printed circuit board (1).

7. Device according to claim 1, **characterized in that** the antenna (8) of the transducer (T) is able to send an electromagnetic field allowing a supply of energy to the label's chip (7) and the exchange of digital signals by means of the antenna (6) of the label (5).

8. Device according to claim 7, **characterized in that** the digital signals comprise a unique identification number originating from the chip (7) via the antenna (6) of the label (5), and **in that** the processor (CPU) comprises periodic analyzing and comparison means of said number with a reference registered during the installation of the security module (3) in the acceptor.

9. Device according to claim 8, **characterized in that** the comparison means are able to detect a label (5) change, respectively the identification number, said change altering the functioning of the apparatus.

10. Device according to claim 1, **characterized in** it comprises means to detect a break of the antenna (6) of the label (5) or of the antenna (8) of the transducer (T), said means being able to disable the apparatus when an antenna (6, 8) is interrupted.

11. Device according to claim 1, in which the acceptor (2, 2', 4) comprises a support (2), located on the printed circuit board (1), having a cover (2') adapted to receive the security module (3), said support (2) having contacts (4) connectable with corresponding contacts of the security module (3) when the cover (2') is fold down on the support (2), **characterized in that** the label (5) is glued simultaneously with the cover (2') of the support (2) and with the printed circuit board (1) so that the acceptor (2, 2', 4) is sealed.

12. Device according to claim 1, in which the acceptor (2, 2', 4) comprises a support (2) with a cover (2'), said support (2), located on the printed circuit board (1) and adapted to receive the security module (3), having contacts (4) connectable with corresponding contacts of the security module (3), **characterized in that** the label (5) is glued simultaneously with the security module (3) and with the printed circuit board (1), the cover (2') being hold closed on the support (2) with a drop of glue (11) deposited on the label (5) in order to close the acceptor (2, 2', 4).

## Patentansprüche

1. Absicherungseinrichtung für eine Steckverbindung eines Sicherheitsmoduls (3), wobei die Steckverbindung Teil eines Halters (2, 2', 4) ist, der auf einer gedruckten Schaltkarte (1) sitzt und in ein Gerät integriert ist, dessen durch einen Prozessor (CPU) gelenkte Funktion von dem mit dem Halter (2, 2', 4) verbundenen Sicherheitsmodul (3) abhängt, **dadurch gekennzeichnet, dass** sie einen ersten Teil umfasst, der aus einem Etikett (5) besteht, das so aufgeklebt ist, dass der Sicherheitsmodul (3) auf der gedruckten Schaltkarte (1) blockiert wird, wobei dieses Etikett (5) zumindest einen Chip (7) sowie eine erste Antenne (6) umfasst, sowie einen zweiten Teil, der in Nachbarschaft zur Steckverbindung angeordnet ist und eine zweite Antenne (8) eines Transducers (T) enthält, der mit dem Prozessor (CPU) des Geräts kommuniziert, wobei der Chip des Etiketts (7) in der Lage ist, über die erste Antenne (6) mit der zweiten Antenne (8) digitale Signale auszutauschen.

2. Vorrichtung nach Anspruch 1, **dadurch gekennzeichnet, dass** das Etikett (5) Rillen (10) aufweist, die sein Zerreissen bei versuchtem Ablösen erleichtern.

3. Vorrichtung nach Anspruch 1, **dadurch gekennzeichnet, dass** das Etikett (5) aus einer Folie aus isolierendem Material besteht, in das eine als Antenne (6) wirkende Leiterbahn und ein Chip (7) eingebettet sind, wobei die Antenne (6) mit dem Chip (7) verbunden ist.

4. Vorrichtung nach Anspruch 1, **dadurch gekennzeichnet, dass** die Antenne (8) des Transducers (T) unter dem Halter (2, 2', 4) angebracht ist.

5. Vorrichtung nach Anspruch 4, **dadurch gekennzeichnet, dass** die Antenne (8) des Transducers (T) in eine dünne Folie (9) eingebettet ist, die Rillen enthält, die ihr Zerreissen bei versuchtem Ablösen erleichtern.

6. Vorrichtung nach Anspruch 1, **dadurch gekennzeichnet, dass** die Antenne (8) des Transducers (T) in Gestalt einer Antennenspule realisiert ist, die auf der gedruckten Schaltkarte (1) eingraviert ist.

7. Vorrichtung nach Anspruch 1, **dadurch gekennzeichnet, dass** die Antenne (8) des Transducers (T) so beschaffen ist, dass sie ein elektromagnetisches Feld aussendet, das die Energieversorgung des Chips (7) des Etiketts (5) und den digitalen Signalaustausch vermittels der Antenne (6) des Etiketts (5) ermöglicht.

8. Vorrichtung nach Anspruch 7, **dadurch gekennzeichnet, dass** die digitalen Signale eine eindeutige ID-Nummer umfassen, die über die Antenne (6) des Etiketts (5) vom Chip (7) kommt, und **dadurch**, dass der Prozessor (CPU) Mittel für eine periodische Analyse und einen Vergleich dieser Nummer mit einer beim Einbau des Sicherheitsmoduls (3) in den Halter aufgezeichneten Referenz aufweist.

9. Vorrichtung nach Anspruch 8, **dadurch gekennzeichnet, dass** die Mittel für den Vergleich so beschaffen sind, dass sie einen Wechsel des Etiketts (5) bzw. der ID-Nummer erkennen, wobei der Wechsel die Funktion des Geräts ändert.

10. Vorrichtung nach Anspruch 1, **dadurch gekennzeichnet, dass** sie Mittel für ein Erkennen eines Bruchs der Antenne (6) des Etiketts (5) oder der Antenne (8) des Transducers (T) umfasst, wobei die Mittel so beschaffen sind, dass das Gerät ausser Betrieb gesetzt wird, wenn zumindest eine Antenne (6, 8) unterbrochen ist.

11. Vorrichtung nach Anspruch 1, in der der Halter (2, 2', 4) einen Träger (2) umfasst, der auf die gedruckte Schaltkarte (1) aufgesetzt ist und mit einem Deckel (2') versehen ist, der dafür geeignet ist, den Sicherheitsmodul (3) aufzunehmen, wobei der Träger (2) Kontakte (4) aufweist, die mit entsprechenden Kontakten des Sicherheitsmoduls (3) in Verbindung treten, wenn der Deckel (2') auf den Träger (2) geklappt wird, **dadurch gekennzeichnet, dass** das Etikett (5) gleichzeitig so auf den Deckel (2') des Trägers (2) und auf die gedruckte Schaltkarte (1) aufgeklebt wird, dass der Halter (2, 2', 4) versiegelt wird.

12. Vorrichtung nach Anspruch 1, in der der Halter (2, 2', 4) einen Träger (2) mit einem Deckel (2') umfasst, wobei der Träger (2), der auf die gedruckte Schaltung (1) aufgesetzt und dafür geeignet ist, den Sicherheitsmodul (3) aufzunehmen, Kontakte (4) aufweist, die mit entsprechenden Kontakten des Sicherheitsmoduls (3) in Verbindung treten, **dadurch gekennzeichnet, dass** das Etikett (5) gleichzeitig auf den Sicherheitsmodul (3) und auf die gedruckte Schaltkarte (1) aufgeklebt wird, wobei der Deckel (2') durch einen auf das Etikett (5) aufgebrachten Tropfen von Kleber (11) so auf den Träger (2) geklappt gehalten wird, dass der Halter (2, 2', 4) verschlossen wird.
